# EUROPEAN PATENT APPLICATION

(11) **EP 4 567 807 A1**
(43) Date of publication of application: **11.06.2025**
(21) Application number: 24217479.5
(22) Date of filing: 04.12.2024
(51) Int. Cl.: G11C 11/406

(54) **MEMORY DEVICE AND OPERATING METHOD OF MEMORY DEVICE**

(30) Priority: 06.12.2023 KR 20230176035; 28.05.2024 KR 20240069560
(71) Applicant: Samsung Electronics Co., Ltd., Suwon-si, Gyeonggi-do 16677 (KR)
(72) Inventor: SHIN, Hoon, Suwon-si, Gyeonggi-do 16677 (KR); SHIN, Minchur, Suwon-si, Gyeonggi-do 16677 (KR); KIM, Ki-Heung, Suwon-si, Gyeonggi-do 16677 (KR); SEOL, Hoseok, Suwon-si, Gyeonggi-do 16677 (KR)
(74) Representative: Kuhnen & Wacker Patent- und Rechtsanwaltsbüro PartG mbB

(57) **Abstract**

A memory device (200) includes a bank (310_1) that includes a plurality of rows each including memory cells and a plurality of count cells storing count data associated with the number of times of access for each of the plurality of rows, and a row hammer management circuit (500) that manages the count data of each of the plurality of rows of the bank. The row hammer management circuit (500) resets count data corresponding to a row, at which a normal refresh operation is performed, from among the plurality of rows.

## Description

### BACKGROUND

A row hammer refers to a phenomenon in which, when a row (e.g., an aggressor row) of a dynamic random access memory (DRAM) is frequently accessed, data of a row(s) (e.g., a victim row(s)) physically adjacent to the corresponding row change.

The row hammer issue may be solved by refreshing the victim row at an appropriate time. In this case, the victim row may be refreshed even through a normal refresh operation targeting all the rows, as well as a row hammer refresh operation targeting the victim row. Accordingly, there is a need to consider the normal refresh operation to cope with the row hammer issue effectively.

### SUMMARY

In general, in some aspects, the present disclosure is directed toward a memory device capable of effectively managing a row hammer issue in consideration of a normal refresh operation and an operating method of the memory device.

According to some implementations, the present disclosure is directed to a memory device that includes a bank that includes a plurality of rows each including memory cells and a plurality of count cells storing count data associated with the number of times of access for each of the plurality of rows, and a row hammer management circuit that manages the count data of each of the plurality of rows of the bank. The row hammer management circuit may reset count data corresponding to a row, at which a normal refresh operation is performed, from among the plurality of rows.

In some implementations, in response to the normal refresh operation associated with one row among the plurality of rows, the row hammer management circuit may reset count data corresponding to the one row.

In some implementations, the memory device may further include a refresh control circuit configured to perform the normal refresh operation based on a refresh command.

In some implementations, the refresh control circuit may output a refresh row address corresponding to the row where the normal refresh operation is performed, based on the refresh command, and the row hammer management circuit may reset count data corresponding to the row where the normal refresh operation is performed, based on the refresh row address.

In some implementations, the refresh control circuit may perform the normal refresh operation on physically adjacent rows sequentially.

In some implementations, the physically adjacent rows may include a first row, a second row adjacent to the first row, and a third row adjacent to the second row, and the refresh control circuit may perform a normal refresh operation on the first row within a first reference interval time (tREFI), may perform the normal refresh operation on the second row within a second tREFI following the first tREFI, and may perform the normal refresh operation corresponding to the third row within a third tREFI following the second tREFI.

In some implementations, the row hammer management circuit may sequentially reset count data corresponding to the physically adjacent rows.

In some implementations, the plurality of rows of the bank may be refreshed one or more times by the normal refresh operation during one refresh window time (tREFW).

In some implementations, the refresh control circuit may perform a row hammer refresh operation on at least one victim row physically adjacent to a management aggressor row, and the management aggressor row may be selected from the plurality of rows based on the count data stored in the plurality of count cells.

In some implementations, when the row hammer refresh operation on the at least one victim row is performed, the row hammer management circuit may reset count data corresponding to the management aggressor row.

According to some implementations, the present disclosure is directed to an operation method of a memory device that includes managing count data being the number of times of access by using count cells of a count cell area of a bank, for each of a plurality of rows, performing a normal refresh operation, and resetting count data corresponding to a row, at which the normal refresh operation is performed, from among the plurality of rows.

In some implementations, the performing of the normal refresh operation may include outputting a refresh row address corresponding to the row where the normal refresh operation is performed, based on a refresh command, and the resetting of the count data may include resetting count data corresponding to the row where the normal refresh operation is performed, based on the refresh row address.

In some implementations, the performing of the normal refresh operation may include performing the normal refresh operation on physically adjacent rows sequentially.

In some implementations, the physically adjacent rows may include a first row, a second row adjacent to the first row, and a third row adjacent to the second row, and the performing of the normal refresh operation may include performing a normal refresh operation on the first row within a first reference interval time (tREFI), performing the normal refresh operation on the second row within a second tREFI following the first tREFI, and performing the normal refresh operation corresponding to the third row within a third tREFI following the second tREFI.

In some implementations, the physically adjacent rows may include a first row, a second row adjacent to the first row, a third row adjacent to the second row, and a fourth row adjacent to the third row, and the performing of the normal refresh operation may include performing a normal refresh operation on the first row and the second row sequentially within a first tREFI, and performing the normal refresh operation on the third row and the fourth row sequentially within a second tREFI following the first tREFI.

In some implementations, the resetting of the count data may include sequentially resetting count data corresponding to the physically adjacent rows.

In some implementations, the method may further include selecting a management aggressor row among the plurality of rows, based on count data corresponding to each of the plurality of rows, and performing a row hammer refresh operation on at least one victim row physically adjacent to the management aggressor row.

In some implementations, the method may further include resetting count data corresponding to the management aggressor row in response the row hammer refresh operation on the at least one victim row.

According to some implementations, the present disclosure is directed to a memory device that includes a bank that includes a plurality of rows and a plurality of count cells storing count data associated with the number of times of access of each of the plurality of rows, and a refresh control circuit that performs a normal refresh operation on the plurality of rows periodically and performs a row hammer refresh operation on a victim row adjacent to a selected management aggressor row based on the count data. Count data corresponding to a row where the normal refresh operation is performed may be reset based on the normal refresh operation, and count data corresponding to the selected management aggressor row may be reset based on the row hammer refresh operation.

### BRIEF DESCRIPTION OF THE FIGURES

Example implementations will be more clearly understood from the following description, taken in conjunction with the accompanying drawings.
FIG. 1 is a block diagram of an example of a memory system according to some implementations.
FIG. 2 is a diagram illustrating an example of a bank according to some implementations.
FIG. 3A is a diagram illustrating an example of a bank in which count cells are included in a count cell area according to some implementations.
FIG. 3B is a diagram illustrating an example of a bank in which count cells and parity cells are included in a count cell area according to some implementations.
FIG. 4 is a block diagram of an example of a memory device according to some implementations.
FIG. 5 is a diagram showing an example of a timing of a normal refresh operation according to some implementations.
FIG. 6 is a timing diagram showing an example of a normal refresh operation of a memory device according to some implementations.
FIG. 7 is a timing diagram showing an example of a normal refresh operation of a memory device according to some implementations.
FIG. 8 is a diagram showing an example of an operation of a memory device according to some implementations.
FIG. 9 is a block diagram of an example of a memory device according to some implementations.
FIG. 10 is a block diagram illustrating an example of a memory device according to some implementations.
FIG. 11 is a flowchart illustrating an example of an operating method of a memory device according to some implementations.
FIG. 12 is a flowchart illustrating an example of an operating method of a memory device according to some implementations.
FIG. 13 is a flowchart illustrating an example of an operating method of a memory device according to some implementations.

### DETAILED DESCRIPTION

Hereinafter, example implementations will be explained in detail with reference to the accompanying drawings.

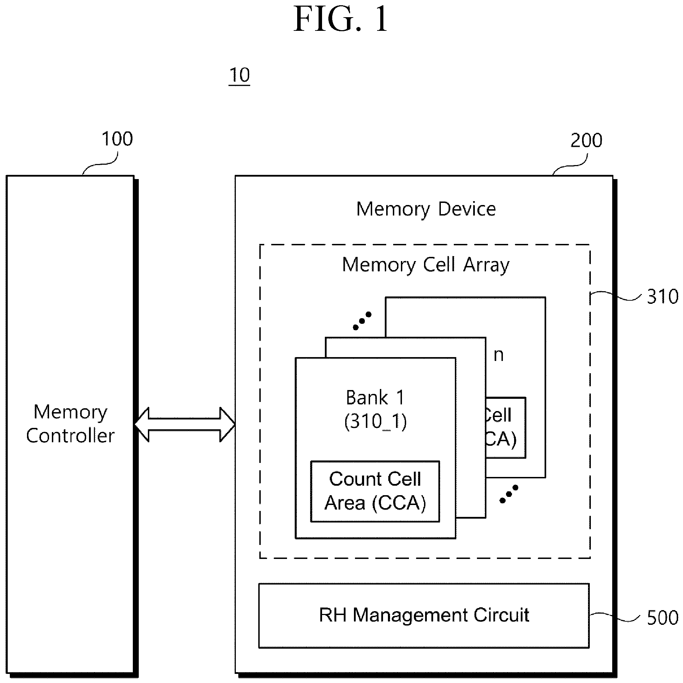

FIG. 1 is a block diagram of an example of a memory system according to some implementations. In FIG. 1, a memory device 200 may include a memory cell array 310, and the memory cell array 310 may include a plurality of count cells respectively corresponding to a plurality of rows. Each count cell may store count data indicating the number of times of access of the corresponding row. In this case, the memory device 200 may perform the row hammer refresh operation by using the count data stored in the plurality of count cells. When the row hammer refresh operation is performed, count data corresponding to a selected management aggressor row among the plurality of rows may be reset.

Additionally, the memory device 200 may include a row hammer management (RH) circuit 500 that manages the count data corresponding to each of the plurality of rows, and the row hammer management circuit 500 may reset count data corresponding to a row, at which the normal refresh operation is performed, from among the plurality of rows. For example, each of the plurality of rows may be refreshed one or more times during a refresh window time (hereinafter referred to as "tREFW"), by the normal refresh operation. In this case, when count data corresponding to a row where the normal refresh operation is performed are not reset, count data of rows which are not selected as a management aggressor row are maintained without modification and continue to increase at a next tREFW. That is, even though a row hammer risk of victim rows is decreased through the normal refresh operation during the previous tREFW, due to rows whose count data remain, victim rows with a low row hammer risk may be preferentially targeted for the row hammer refresh operation at a next tREFW. This causes a result of depriving rows with an actually high row hammer risk of a row hammer mitigation opportunity, thereby making it difficult to set an upper bound of the number of times of disturb of a victim row.

However, according to some implementations, because count data corresponding to a row where the normal refresh operation is performed, the above issue does not occur, and the upper bound of the number of times of disturb of a victim row may be set through the row hammer refresh operation which uses a count cell. Accordingly, the row hammer issue is effectively managed.

In FIG. 1, a memory system 10 may include a memory controller 100 and the memory device 200. The memory controller 100 may control the memory device 200. For example, the memory controller 100 may control the memory device 200 depending on a request of a processor supporting various applications, such as a server application, a personal computer (PC) application, and a mobile application. For example, the memory controller 100 may be included in a host device including a processor and may control the memory device 200 depending on a request of the processor.

To control the memory device 200, the memory controller 100 may transmit a command and/or an address to the memory device 200. Also, the memory controller 100 may transmit data to the memory device 200 or may receive data from the memory device 200.

The memory device 200 may receive data from the memory controller 100 and may store the received data. In response to a request of the memory controller 100, the memory device 200 may read the stored data and may transmit the read data to the memory controller 100.

In some implementations, the memory device 200 may be a memory device including volatile memory cells. For example, the memory device 200 may include various dynamic random access memory (DRAM) devices, such as a double data rate synchronous DRAM (DDR SDRAM), a DDR2 SDRAM, a DDR3 SDRAM, a DDR4 SDRAM, a DDR5 SDRAM, a DDR6 SDRAM, a low power double data rate (LPDDR) SDRAM, an LPDDR2 SDRAM, an LPDDR3 SDRAM, an LPDDR4 SDRAM, an LPDDR4X SDRAM, an LPDDR5 SDRAM, an LPDDR6 SDRAM, a graphics double data rate synchronous graphics random access memory (GDDR SGRAM), a GDDR2 SGRAM, a GDDR3 SGRAM, a GDDR4 SGRAM, a GDDR5 SGRAM, and a GDDR6 SGRAM.

In some implementations, the memory device 200 may be a stacked memory device, in which DRAM dies are stacked, such as a high bandwidth memory (HBM), an HBM2, or an HBM3.

In some implementations, the memory device 200 may be a memory module, such as a dual in-line memory module (DIMM). For example, the memory device 200 may be a registered DIMM (RDIMM), a load reduced DIMM (LRDIMM), an unbuffered DIMM (UDIMM), a fully buffered DIMM (FB-DIMM), or a small outline DIMM (SO-DIMM). However, this is provided as an example, and the memory device 200 may be any other memory module such as a single in-line memory module (SIMM).

In some implementations, the memory device 200 may be an SRAM device, a NAND flash memory device, a NOR flash memory device, an RRAM device, an FRAM device, a PRAM device, a TRAM device, an MRAM device, etc.

The memory device 200 may include the memory cell array 310 and the row hammer management circuit 500. The memory cell array 310 may include a plurality of banks 310_1 to 310_n, each of which includes memory cells for storing data. For convenience of description, in the present disclosure, it is assumed that each bank includes DRAM cells. However, this is provided as an example, and each of the plurality of banks 310_1 to 310_n may be implemented to include any other volatile memory cells except for the DRAM cells. Also, the plurality of banks 310_1 to 310_n may be implemented to include the same kind of memory cells. According to some implementations, the plurality of banks 310_1 to 310_n may be implemented to include different kinds of memory cells.

Each of the plurality of banks 310_1 to 310_n may include a plurality of rows. In some implementations, the row may refer to a conductive line which is disposed to extend in a row direction and is electrically connected to memory cells. For example, one row may refer to one word line disposed to extend in the row direction. However, this is provided as an example. According to some implementations, one row may refer to a plurality of word lines disposed to extend in the row direction.

Each of the plurality of banks 310_1 to 310_n may include a count cell area CCA. The count cell area CCA may include a plurality of count cells, and each of the plurality of count cells may store the number of times of access of the corresponding row as count data. For example, when a target row is accessed, count data may be read from a count cell corresponding to the target row being in an active state. Afterwards, the read count data may be modified, and the modified count data may be again written to the count cell corresponding to the target row. The number of times of access of each of the plurality of rows may be stored in the corresponding count cell through a read-modify-write (RMW) operation. The count data stored in the count cell may be referred to as "per row activation count data or PRAC data"

According to some implementations, some of memory cells connected to one row may be used as a count cell. In this case, the count cell area CCA may include count cells associated with each of the plurality of rows. In some implementations, some of memory cells connected to one row may be used as a count cell, and others thereof may be used as a parity cell. The parity cell may store parity data for performing an error correction operation on count data. In this case, the count cell area CCA may include count cells and parity cells for each of the plurality of rows.

In FIG. 1, each of the plurality of banks 310_1 to 310_n includes the count cell area CCA. However, this is provided as an example. According to some implementations, some of the plurality of banks 310_1 to 310_n may not include the count cell area CCA. In some implementations, different banks may share the same count cell area CCA. For example, when different banks share the same word line, only any one bank among the different banks may include the count cell area CCA, and the remaining banks may share and use the corresponding count cell area CCA.

The row hammer management circuit 500 may manage count data for each of a plurality of rows of a bank. In this case, the management of count data may include the generation, modification, reset, etc. of count data. For example, the row hammer management circuit 500 may count the number of times of access of a target row based on a command received from the memory controller 100 and may store the number of times of access thus counted in the count cell. For example, when a word line is activated depending on an activation (ACT) command received from the memory controller 100, the row hammer management circuit 500 may count the number of times of access of a target row corresponding to the activated word line. Afterwards, the row hammer management circuit 500 may store count data being the number of times of access in a count cell associated with the corresponding target row. However, this is provided as an example, and the row hammer management circuit 500 may count the number of times of access of the target row based on a precharge (PRE) command.

According to some implementations, the row hammer management circuit 500 may perform the RMW operation to manage count data of each of the plurality of rows. For example, when the activation command for the target row is applied from the memory controller 100, the row hammer management circuit 500 may perform the RMW operation by reading count data from a count cell of the target row, generating modified count data by increasing the read count data as much as "1", and again writing the modified count data to the count cell of the target row. According to some implementations, the row hammer management circuit 500 may manage the count data of each of the plurality of rows further in consideration of an activation time of the target row. In this case, when the activation time of the target row exceeds a reference time, the row hammer management circuit 500 may further increase the count data additionally.

Additionally, the row hammer management circuit 500 may reset count data. In this case, the reset may refer to an operation of changing or setting count data to a reset value. The reset value may be, for example, "0," but the present disclosure is not limited thereto. For example, the row hammer management circuit 500 may reset count data corresponding to a management aggressor row based on the row hammer refresh operation. The row hammer refresh operation may refer to an operation of refreshing a victim row(s) independently of the normal refresh operation.

For example, when the memory device 200 has a row hammer refresh opportunity, the memory device 200 may perform the row hammer refresh operation. Herein, the row hammer refresh opportunity may include the case where a refresh (REF) command is applied from the memory controller 100 or the case where a refresh management (RFM) command is applied from the memory controller 100. However, the present disclosure is not limited thereto. For example, the memory device 200 may perform the row hammer refresh operation in an idle state or when the background operation is performed.

In some implementations, the memory device 200 may perform the row hammer refresh operation based on count data stored in a plurality of count cells. For example, the memory device 200 may select a management aggressor row among the plurality of rows based on the count data stored in the plurality of count cells. According to some implementations, the memory device 200 may select, as a management aggressor row, a row corresponding to count data with a relatively large value from among the plurality of rows, but the present disclosure is not limited thereto. Accordingly, the memory device 200 may perform the row hammer refresh operation on a victim row(s) physically adjacent to the management aggressor row.

After the row hammer refresh operation is performed, because the risk at which the row hammer due to the access to the management aggressor row occurs at a victim row(s) is removed, the row hammer management circuit 500 may reset the count data corresponding to the management aggressor row.

Meanwhile, the row hammer management circuit 500 may reset count data corresponding to a row where the normal refresh operation is performed. For example, in response to the normal refresh operation on one row among the plurality of rows, the row hammer management circuit 500 may reset count data corresponding to the one row.

In some implementations, a time from a point in time when data (e.g., "0" or "1") are written to a memory cell of the memory device 200 to a point in time when the written data are incapable of being read due to the loss of the written data may be defined as a "retention time." To guarantee the data integrity, each memory cell of the memory device 200 should be refreshed one or more times before the retention time passes. To this end, the memory controller 100 may periodically transmit the refresh (REF) command to the memory device 200, and the memory device 200 may refresh all the memory cells little by little based on the received refresh (REF) command. The above refresh operation of the memory device 200 may refer to the normal refresh operation.

The normal refresh operation may be identically performed for each bank of the memory cell array 310 or may be differently performed for each bank. In any case, all the rows of each bank may be refreshed one or more times within the retention time or the refresh window time tREFW through the normal refresh operation. In this case, whenever the normal refresh operation is performed, the row hammer management circuit 500 may reset count data corresponding to a refreshed row(s). According to the present disclosure, the count data corresponding to all the rows of the bank may be reset one or more times during the retention time or the refresh window time tREFW. Accordingly, the above issue, that is, issues which occur when count data remain even though the row hammer risk of victim rows decreases through the normal refresh operation may be solved.

Meanwhile, as described above, the memory device 200 may perform the row hammer refresh operation based on count data being the number of times of access of each row. That is, the memory device 200 may perform the row hammer refresh operation on a victim row(s) adjacent to an aggressor row based on count data of the aggressor row. In this case, the reset operation on the count data of the aggressor row may be based on the presumption that the row hammer risk of the victim row(s) decreases through the row hammer refresh operation. The reason is that, when count data of an aggressor row are reset even though the row hammer risk of a victim row(s) is in a high state, in some cases, the row hammer refresh opportunity of the victim row(s) is deprived, that is, data stored at the victim row(s) are capable of being changed.

This is also applied when count data are reset through the normal refresh operation. That is, to reset count data of a row (e.g., A) refreshed through the normal refresh operation, there is a need to decrease the row hammer risk of a row(s) (e.g., (A - 1) and/or (A + 1)) adjacent to the corresponding row "A." To this end, the adjacent row(s) (A - 1) and/or (A + 1) may be refreshed at a time point close to a point in time when the count data of the corresponding row "A" are reset.

In some implementations, the memory device 200 may sequentially perform the normal refresh operations on physically adjacent rows. For example, the memory device 200 may perform the normal refresh operation in order of (A - 1), A, and (A + 1) (or (A + 1), A, and (A - 1)) in association with three adjacent rows (A - 1), A, and (A + 1). In this case, even though the count data corresponding to the row "A" are reset, the adjacent rows (A - 1) and (A + 1) may be refreshed through the normal refresh operation at a near time point. Accordingly, the probability that there occurs the issue that the row hammer refresh opportunity of the adjacent rows (A - 1) and (A + 1) is deprived due to the reset of the count data of the row "A" may be minimized.

Meanwhile, as described above, whenever the normal refresh operation is performed, the row hammer management circuit 500 may reset count data corresponding to a row where the normal refresh operation is performed. Accordingly, count data corresponding to physically adj acent rows may be sequentially reset depending on the order of the normal refresh operation.

According to the present disclosure, the row hammer issue may be effectively managed. Accordingly, the performance and reliability of a memory device may be improved.

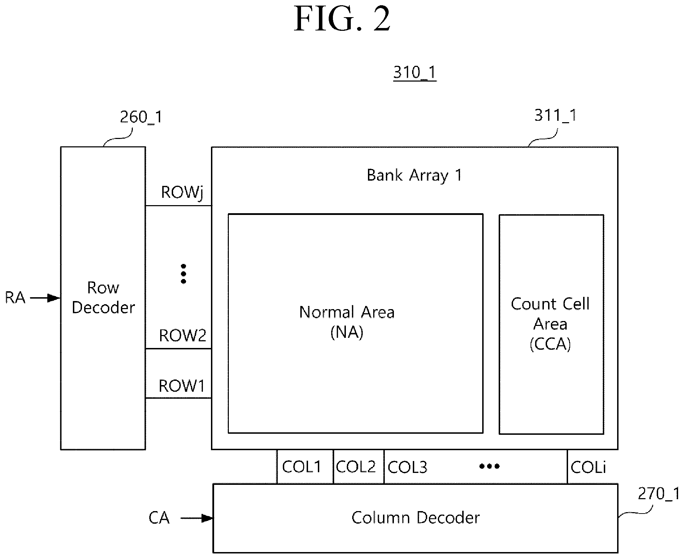

FIG. 2 is a diagram illustrating an example of a bank according to some implementations. In FIG. 2, the bank 310_1 may correspond to the first bank 310_1 of FIG. 1, but the present disclosure is not limited thereto. In FIG. 2, the first bank 310_1 may include a first bank array 311_1, a row decoder 260_1, and a column decoder 270_1.

The first bank array 311_1 may include a plurality of memory cells. The first bank array 311_1 may include a normal area NR and the count cell area CCA. The normal area NR may refer to an area of the first bank array 311_1, which is allocated to store user data. In some implementations, the normal area NR may refer to the remaining area of the first bank array 311_1 other than an area allocated to the count cell area CCA. The count cell area CCA may refer to an area of the first bank array 311_1, which is allocated to store count data for each of a plurality of rows ROW1 to ROWj .

The row decoder 260_1 may activate one of the plurality of rows ROW1 to ROWj in response to a row address RA. For example, each of the plurality of rows ROW 1 to ROWj may correspond to a word line.

The column decoder 270_1 may activate one of a plurality of columns COL1 to COLi in response to a column address CA. For example, each of the plurality of columns COL1 to COLi may correspond to a column selection line (CSL). However, this is provided as an example. According to some implementations, each of the plurality of columns COL1 to COLi may correspond to a bit line.

According to some implementations, the count cell area CCA may include count cells for storing the count data for the plurality of rows ROW1 to ROWj. In some implementations, the count cell area CCA may include count cells for storing the count data for the plurality of rows ROW1 to ROWj and parity cells for performing the error correction operation on the count data.

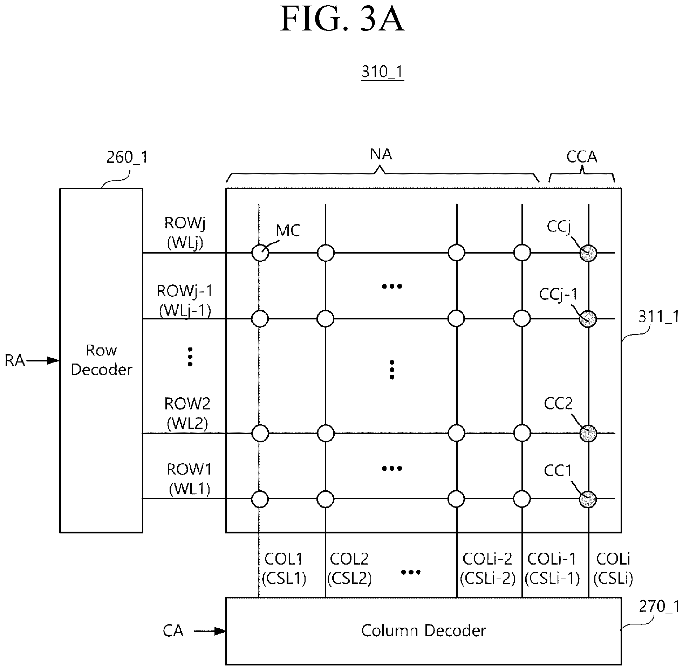

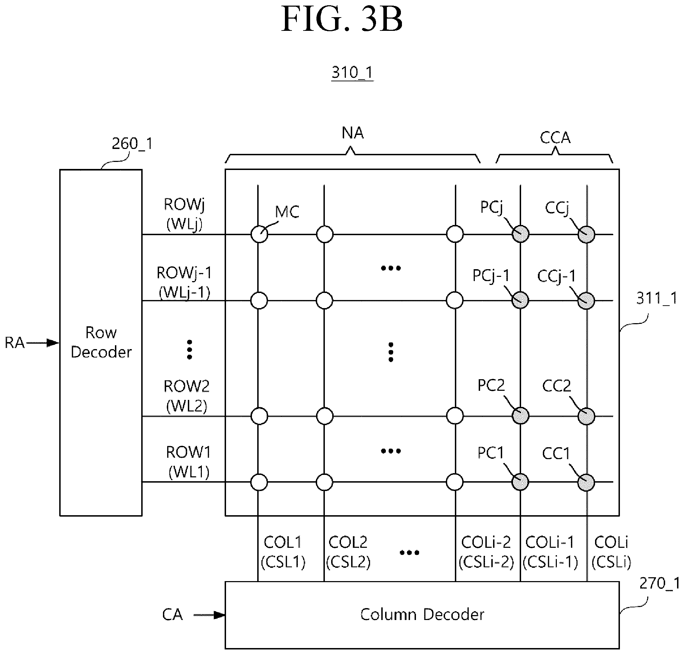

FIG. 3A is a diagram illustrating an example of a bank in which count cells are included in the count cell area CCA according to some implementations. FIG. 3B is a diagram illustrating an example of a bank in which count cells and parity cells are included in the count cell area CCA according to some implementations. In FIGS. 3A and 3B, the bank 310_1 may correspond to the first bank 310_1 of FIGS. 1 and 2, but the present disclosure is not limited thereto.

In FIGS. 3A and 3B, the first bank 310_1 may include the first bank array 311_1, the row decoder 260_1, and the column decoder 270_1. The first bank array 311_1 may include a plurality of memory cells which are electrically connected to a plurality of word lines WL1 to WLj and a plurality of column selection lines CSL1 to CSLi. The plurality of word lines WL1 to WLj may be defined as the plurality of rows ROW1 to ROWj, and the plurality of column selection lines CSL1 to CSLi may be defined as the plurality of columns COL1 to COLi.

A portion of the first bank array 311_1 may be allocated to the normal area NR, and the remaining portion thereof may be allocated to the count cell area CCA.

In some implementations, as illustrated in FIG. 3A, memory cells corresponding to one of the plurality of columns COL1 to COLi may be allocated to the count cell area CCA. Accordingly, each of a plurality of memory cells CC1 to CCj allocated to the count cell area CCA may store count data of the corresponding row. The memory cells CC1 to CCj storing the count data may be referred to as "count cells." For example, the first count cell CC1 may store count data of the first row ROW1, the second count cell CC2 may store count data of the second row ROW2, and the j-th count cell CCj may store count data of the j-th row ROWj.

In some implementations, as illustrated in FIG. 3B, memory cells corresponding to at least two of the plurality of columns COL1 to COLi may be allocated to the count cell area CCA. In this case, each of the plurality of memory cells CC1 to CCj corresponding to the i-th column COLi may store count data for the corresponding row. Also, each of a plurality of memory cells PC1 to PCj corresponding to the (i-1)-th column COLi-1 may store parity data for the count data. The memory cells PC1 to PCj storing the parity data may be referred to as a "parity cell." For example, the first parity cell PC1 may store parity data associated with the count data stored in the first count cell CC1, the second parity cell PC2 may store parity data associated with the count data stored in the second count cell CC2, and the j-th parity cell PCj may store parity data associated with the count data stored in the j-th count cell CCj.

The count data and/or the parity data for each of the plurality of rows ROW1 to ROWj may be managed in the count cell area CCA of the first bank 310_1 through the above method.

In FIGS. 3A and 3B, the description is given as memory cells corresponding to one of the plurality of columns COL1 to COLi are allocated to count cells or parity cells. However, this is provided as an example. According to some implementations, memory cells corresponding to at least two of the plurality of columns COL1 to COLi may be allocated to count cells, and memory cells corresponding to at least two of the plurality of columns COL1 to COLi may be allocated to parity cells.

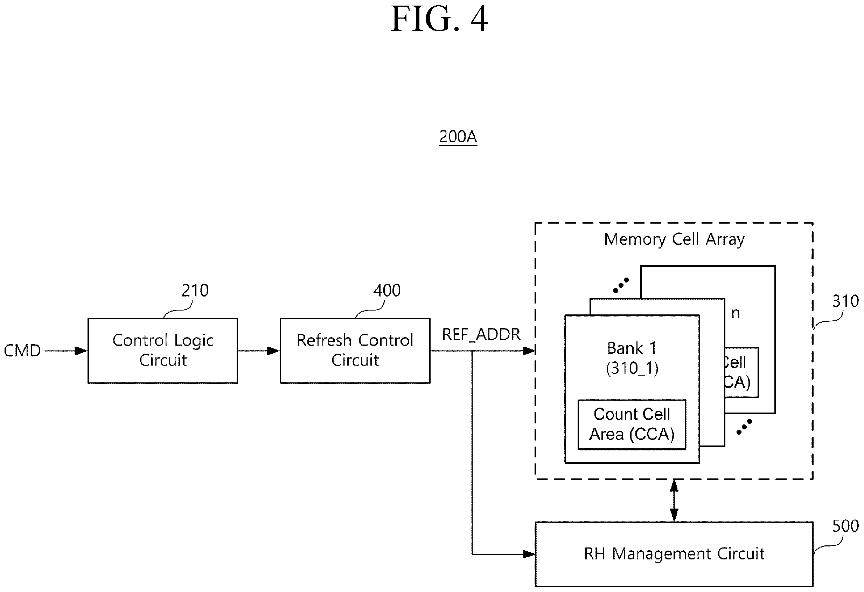

FIG. 4 is a block diagram of an example of a memory device according to some implementations. In FIG. 4, a memory device 200A may be an implementations of the memory device 200 of FIG. 1, but the present disclosure is not limited thereto. In describing FIG. 4, the description which is given above will be omitted or simplified.

In FIG. 4, the memory device 200A may include a control logic circuit 210, a refresh control circuit 400, the memory cell array 310, and the row hammer management circuit 500. The memory cell array 310 is described detail with reference to FIGS. 1 to 3B, and thus, additional description will be omitted to avoid redundancy.

The control logic circuit 210 may control an operation of the memory device 200A. For example, the control logic circuit 210 may generate control signals such that the memory device 200A performs the write operation, the read operation, the normal refresh operation, and the row hammer refresh operation. The control logic circuit 210 may decode a command CMD received from the memory controller 100 and may generate control signals corresponding to the command CMD.

The refresh control circuit 400 may perform various kinds of refresh operations by outputting a refresh row address REF_ADDR to banks of the memory cell array 310 under control of the control logic circuit 210. For example, the refresh control circuit 400 may perform the normal refresh operation based on the refresh (REF) command. For example, when the refresh (REF) command is applied from the memory controller 100, the control logic circuit 210 may allow the refresh control circuit 400 to perform the normal refresh operation. Accordingly, the refresh control circuit 400 may perform the normal refresh operation by outputting the refresh row address REF_ADDR corresponding to a row where the normal refresh operation is to be performed.

In this case, according to some implementations, the refresh control circuit 400 may sequentially perform the normal refresh operations on physically adjacent rows.

In some implementations, the refresh control circuit 400 may sequentially perform the normal refresh operations on physically adjacent rows through an auto-refresh operation. In this case, the refresh control circuit 400 may sequentially output addresses of the physically adjacent rows as the refresh row address REF_ADDR whenever the refresh (REF) command is applied.

In some implementations, the refresh control circuit 400 may sequentially perform the normal refresh operations on physically adjacent rows through a self-refresh operation. In this case, after a refresh start signal is received from the memory controller 100, until a refresh end signal is received from the memory controller 100, the refresh control circuit 400 may periodically perform the normal refresh operation depending on an internally defined period. In this case, the refresh control circuit 400 may sequentially output addresses of physically adjacent rows as the refresh row address REF_ADDR whenever the normal refresh operation is periodically performed.

To sequentially output the addresses of the physically adjacent rows as the refresh row address REF ADDR, the refresh control circuit 400 may increase a value of a refresh counter as much as "+1", but the present disclosure is not limited thereto.

In some implementations, the row hammer management circuit 500 may reset count data corresponding to a row where the normal refresh operation is performed. For example, the row hammer management circuit 500 may reset count data corresponding to a row where the normal refresh operation is performed, based on the refresh row address REF_ADDR output from the refresh control circuit 400, and the present disclosure is not limited thereto.

When a row hammer refresh opportunity is given, the refresh control circuit 400 may perform the row hammer refresh operation. In some implementations, the row hammer refresh opportunity may include the case where the refresh (REF) command is applied from the memory controller 100 or the case where the refresh management (RFM) command is applied from the memory controller 100. However, the present disclosure is not limited thereto. For example, the memory device 200 may also have the row hammer refresh opportunity in an idle state or when the background operation is performed. For example, when the row hammer refresh opportunity is given, the control logic circuit 210 may allow the refresh control circuit 400 to perform the row hammer refresh operation. Accordingly, the refresh control circuit 400 may perform the row hammer refresh operation by outputting the refresh row address REF_ADDR corresponding to a victim row(s) physically adjacent to a management aggressor row.

In some implementations, when a row hammer refresh opportunity is given, the refresh control circuit 400 may receive a row hammer address RH_ADDR. When a row hammer refresh opportunity is given, the row hammer management circuit 500 may select a management aggressor row among a plurality of rows based on count data stored in a plurality of count cells. For example, the row hammer management circuit 500 may select, as a management aggressor row, a row corresponding to count data with a relatively large value from among the plurality of rows, but the present disclosure is not limited thereto. In this case, the row hammer management circuit 500 may provide the row hammer address RH_ADDR corresponding to the selected management aggressor row to the refresh control circuit 400. In some implementations, when a row hammer refresh opportunity is given, the control logic circuit 210 may select a management aggressor row based on count data stored in a plurality of count cells and may provide the row hammer address RH_ADDR corresponding to the selected management aggressor row to the refresh control circuit 400. Accordingly, the refresh control circuit 400 may output the refresh row address REF_ADDR corresponding to a victim row(s) physically adjacent to the management aggressor row based on the received row hammer address RH_ADDR.

When the row hammer refresh operation on the victim row(s) is performed, the row hammer management circuit 500 may reset count data stored in a count cell corresponding to the management aggressor row.

Additionally, the case where the row hammer management circuit 500 is provided as a component independent of the control logic circuit 210 and is disposed outside the control logic circuit 210 is illustrated in FIG. 4, as an example, but the present disclosure is not limited thereto. According to some implementations, the row hammer management circuit 500 may be implemented to be included in the control logic circuit 210.

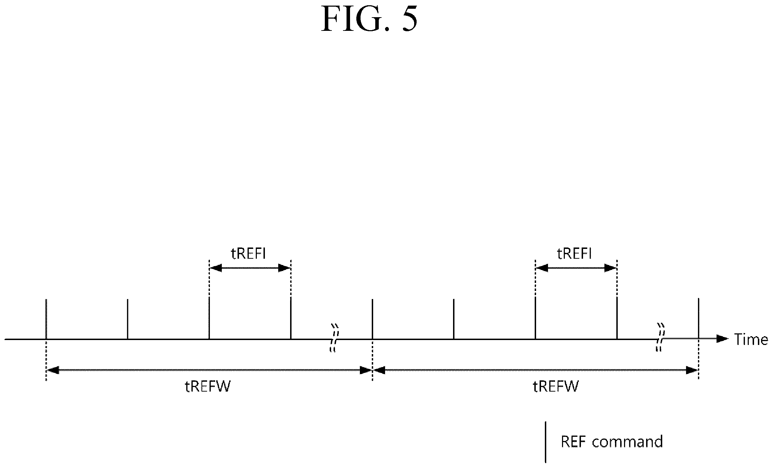

FIG. 5 is a diagram for describing an example of a timing of a normal refresh operation according to some implementations. In FIG. 5, the refresh window time tREFW of 32 ms (milli-seconds) or 64 ms which is defined in the joint electron device engineering council (JEDEC) standard may be set as illustrated. In this case, the memory controller 100 may transmit the refresh (REF) command to the memory device 200 every reference interval time tREFI, and a time corresponding to a reference cycle time (hereinafter referred to as "tRFC") may be given to the memory device 200 every reference interval time tREFI. As an example, according to the DDR5 specification, the tREFI may be 3.9 µs (micro-seconds). Also, in the 16Gb DDR5 memory device, the tRFC may be 295 ns (nano-seconds).

During the tRFC, the condition that the memory controller 100 does not transmit any other command to a corresponding rank may be guaranteed. Accordingly, the memory device 200 may internally perform the normal refresh operation on plural rows by utilizing the tRFC.

As described above, by utilizing a time periodically provided for normal refresh, the memory device 200 should perform the normal refresh operation such that all the rows of the bank are refreshed one or more times within the tREFW or the retention time. For example, assuming that the tREFI is 7.8 µs and the tREFW is 64 ms, the tRFC may be given to the memory device 200 about 8k times during the tREFW. In this case, it is understood that, assuming that the number of word lines of the bank of the memory device 200 is 64k, 8 word lines should be refreshed one or more times every normal refresh operation to refresh all the cells of the bank within the tREFW or the retention time.

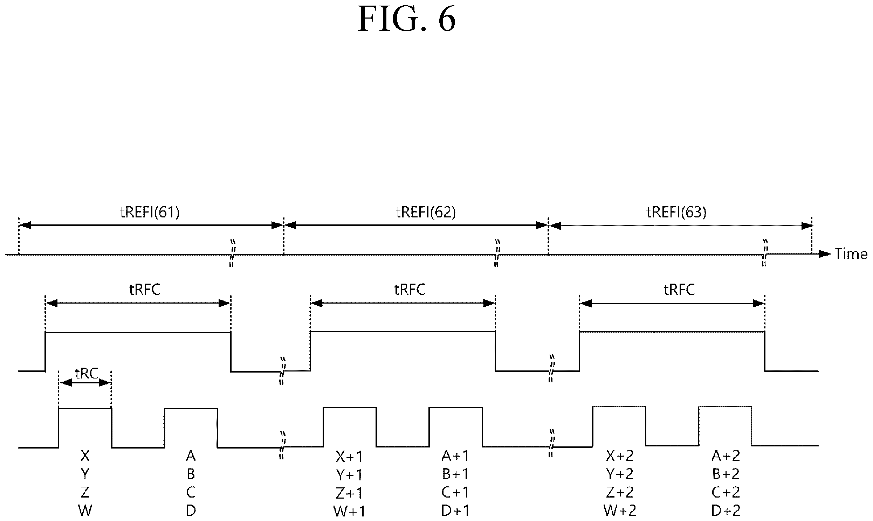

FIG. 6 is a timing diagram showing an example of a normal refresh operation of a memory device according to some implementations. FIG. 6 illustrates an example in which normal refresh operations on rows are performed by utilizing a given tRFC given to each of three continuous tREFIs 61, 62, and 63.

In FIG. 6, X, (X + 1), and (X + 2) may indicate rows physically adjacent to each other. Also, A, (A + 1), and (A + 2) may indicate rows physically adjacent to each other. The above description is also applied to rows Y, Z, W, B, C, and D expressed by other nomenclature.

As described above, the refresh control circuit 400 may sequentially perform the normal refresh operations on physically adjacent rows. In this case, according to some implementations, the refresh control circuit 400 may perform the normal refresh operations on the physically adjacent rows respectively within the tREFIs close to each other on time. For example, the refresh control circuit 400 may perform the normal refresh operation such that the physically adjacent rows (e.g., X, (X + 1), and (X + 2)) are refreshed one by one every tREFI. In FIG. 6, the refresh control circuit 400 may perform the normal refresh operation on a first row (e.g., X) within the first tREFI 61, may perform the normal refresh operation on a second row (e.g., (X + 1)) adjacent to the first row within the second tREFI 62, and may perform the normal refresh operation on a third row (e.g., (X + 2)) adjacent to the second row within the third tREFI 63. The above description may also be applied to rows Y, Z, W, A, B, C, and D expressed by other nomenclature.

In this case, according to some implementations, count data corresponding to X, count data corresponding to (X + 1), and count data corresponding to (X + 2) may be sequentially reset in response to the normal refresh operations of respective rows. The above description may also be applied to rows Y, Z, W, A, B, C, and D expressed by other nomenclature.

Additionally, a time (e.g., a row cycle time tRC) taken to perform the normal refresh operation on one row may be shorter than the tRFC. Accordingly, the refresh control circuit 400 may sequentially perform the normal refresh operation plural times. FIG. 6 shows an example in which the normal refresh operation is performed two times within each tRFC.

Additionally, because rows respectively connected to sense amplifier blocks capable of operating independently of each other are simultaneously accessed, the rows may be simultaneously refreshed. Accordingly, the refresh control circuit 400 may perform the normal refresh operations on a plurality of rows within one row cycle time tRC. FIG. 6 shows an example in which 4 rows are simultaneously refreshed within one row cycle time tRC.

In FIG. 6, for example, X, (X + 1), and (X + 2) may be connected to a first sense amplifier block; Y, (Y + 1), and (Y + 2) may be connected to a second sense amplifier block; Z, (Z + 1), and (Z + 2) may be connected to a third sense amplifier block; and W, (W + 1), and (W + 2) may be connected to a fourth sense amplifier block. In this case, the first to fourth sense amplifier blocks may operate independently of each other. Accordingly, X, Y, Z, and W may be simultaneously refreshed. The above description may also be applied to A, B, C, and D.

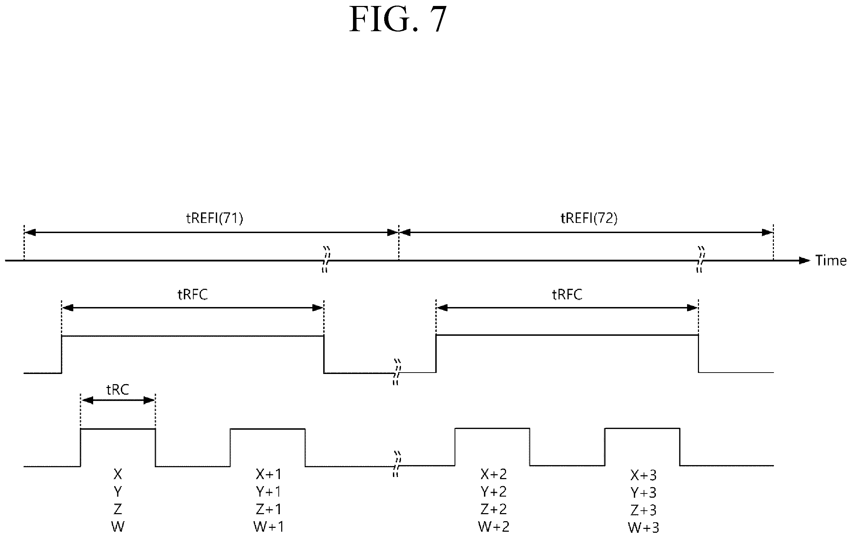

FIG. 7 is a timing diagram showing an example of a normal refresh operation of a memory device according to some implementations. FIG. 7 illustrates an example in which the normal refresh operations on rows are performed by utilizing a given tRFC given to each of two continuous tREFIs 71 and 72. In describing FIG. 7, the description which is given with reference to FIG. 6 will be omitted or simplified.

In FIG. 7, X, (X + 1), (X + 2), and (X + 3) may indicate rows physically adjacent to each other. The above description is also applied to rows Y, Z, and W expressed by other nomenclature.

As described above, the refresh control circuit 400 may perform the normal refresh operation plural times during one tRFC. Accordingly, the refresh control circuit 400 may perform the normal refresh operation such that a plurality of rows physically adjacent are refreshed within one tREFI. FIG. 7 shows an example in which the normal refresh operations on two rows physically adjacent to each other are performed within one tREFI. Even in this case, of course, the normal refresh operations on physically adjacent rows should be sequentially performed.

In FIG. 7, the refresh control circuit 400 may sequentially perform the normal refresh operation on a first row (e.g., X) and the normal refresh operation on a second row (e.g., (X + 1)) adjacent to the first row within the first tREFI 71. Also, the refresh control circuit 400 may sequentially perform the normal refresh operation on a third row (e.g., X +2)) adjacent to the second row and the normal refresh operation on a fourth row (e.g., (X + 3)) adjacent to the third row within the second tREFI 72. The above description is also applied to rows Y, Z, and W expressed by other nomenclature.

In this case, according to some implementations, count data corresponding to X, count data corresponding to (X + 1), count data corresponding to (X + 2), and count data corresponding to (X + 3) may be sequentially reset in response to the normal refresh operations of respective rows. The above description is also applied to rows Y, Z, and W expressed by other nomenclature.

Additionally, in FIGS. 6 and 7, the example in which the normal refresh operations on physically adjacent rows (e.g., X, (X + 1), and (X+2)) are performed in order of X, (X + 1), and (X+2) is described. However, the present disclosure is not limited thereto. For example, the refresh control circuit 400 may perform the normal refresh operations in order of (X + 2), (X + 1), and X. The above description may also be applied to rows Y, Z, W, A, B, C, and D expressed by other nomenclature.

Additionally, comparing FIG. 7 with FIG. 6, physically adjacent rows are refreshed at a relatively nearer time point in FIG. 7. Accordingly, for example, the probability that the row hammer refresh opportunity of the adjacent rows X and (X + 2) is deprived due to the reset of count data of the row (X + 1) may be relatively lower in FIG. 7. Meanwhile, in FIG. 7, because physically adjacent rows are refreshed one by one every tREFI. Accordingly, FIG. 7 may be relatively advantageous in terms of a power noise.

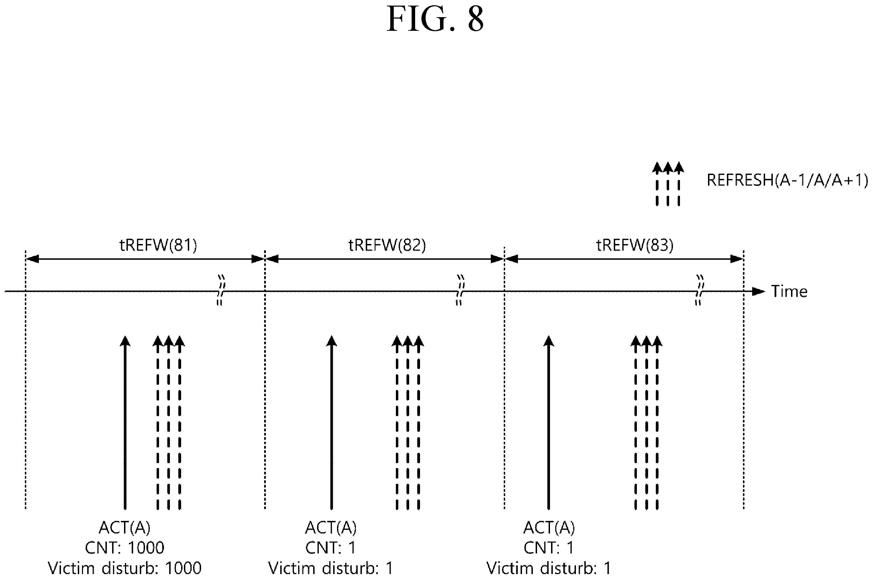

FIG. 8 is a diagram showing an example of an operation of the memory device 200 according to some implementations. In FIG. 8, three dotted arrows represent sequential normal refresh operations on physically adjacent rows (A - 1), A, and (A + 1), and a solid arrow represents an access operation to the row A. In FIG. 8 the situation that the row A is an aggressor row and the rows (A - 1) and (A + 1) are victim rows will be described as an example.

In FIG. 8, as the row A is accessed 1000 times within a first tREFW 81, count data CNT of the row A may be 1000. In this case, because the row A is accessed 1000 times, the number of times of disturb of the victim rows (A - 1) and (A + 1) adjacent to the row A may be 1000.

Additionally, as described with reference to FIG. 5, all the rows of the bank of the memory device 200 may be refreshed at least one or more times by the normal refresh operation during one tREFW. In FIG. 8, the memory device 200 may sequentially perform the normal refresh operations on physically adjacent rows (A - 1), A, and (A + 1) within the first tREFW 81.

In this case, the memory device 200 may reset count data corresponding to a row where the normal refresh operation is performed. Accordingly, the count data CNT of the row A may be reset to "0" at a point in time when the normal refresh operation on the row A is performed.

Even though the normal refresh operation on the row A is performed, that the normal refresh operation on the row A is performed does not mean that the row hammer refresh for the victim rows (A - 1) and (A + 1) corresponding to the row A are performed. However, because the rows (A - 1), A, and (A + 1) are sequentially normal-refreshed every tREFI, the victim rows (A - 1) and (A + 1) may be normal-refreshed at a time point very close to a point in time when the count data CNT of the row A are reset (i.e., when the row A is normal-refreshed).

Accordingly, when the normal refresh operations on the victim rows (A - 1) and (A + 1) of the row A are performed at a time point very close to the normal refresh operation on the row A, even though the row hammer refresh operation on the victim rows (A - 1) and (A + 1) is not performed, the number of times of disturb of the victim rows (A - 1) and (A + 1) may be "0."

For example, as not only the normal refresh operation on the row A, but also the normal refresh operations on the victim rows (A - 1) and (A + 1) are performed during the first tREFW 81, the number of times of disturb of the victim rows (A - 1) and (A + 1) of the row A may be "0" without the row hammer refresh operation.

Afterwards, when the row A is accessed within a second tREFW 82, the count data CNT of the row A may be set to "1," the number of times of disturb of the victim rows (A - 1) and (A + 1) may also be set to "1." That is, the count data CNT of the row A may exactly express the number of times of disturb of the victim rows (A - 1) and (A + 1).

When count data are not reset in the normal refresh operation, the count data of the row A may maintain 1000. That is, even though the number of times of disturb of the victim rows (A - 1) and (A + 1) is set to "0" by the normal refresh operation performed during the first tREFW 81, the count data of the row A may remain at 1000. Afterwards, when the row A is accessed within the second tREFW 82, the number of times of disturb of the victim rows (A - 1) and (A + 1) is "1," but the count data CNT of the row A is continuously increased to 1001. That is, the false-positive phenomenon that the count data CNT of the row A associated with the victim rows (A - 1) and (A + 1) with an actually low risk is maintained at a high value may occur.

Because the memory device 200 performs the row hammer refresh operation based on count data, the probability that the victim rows (A - 1) and (A + 1) with a low row hammer risk are targeted for the row hammer refresh operation within the second tREFW 82 becomes higher. This results in depriving rows with an actually high row hammer risk of a row hammer mitigation opportunity, thereby making it difficult to set an upper bound of the number of times of disturb of a victim row.

However, according to some implementations, because count data corresponding to a row where the normal refresh operation is performed are reset, the above issue may not occur, and the risk of occurrence of the row hammer may be effectively managed to be an appropriate level or lower.

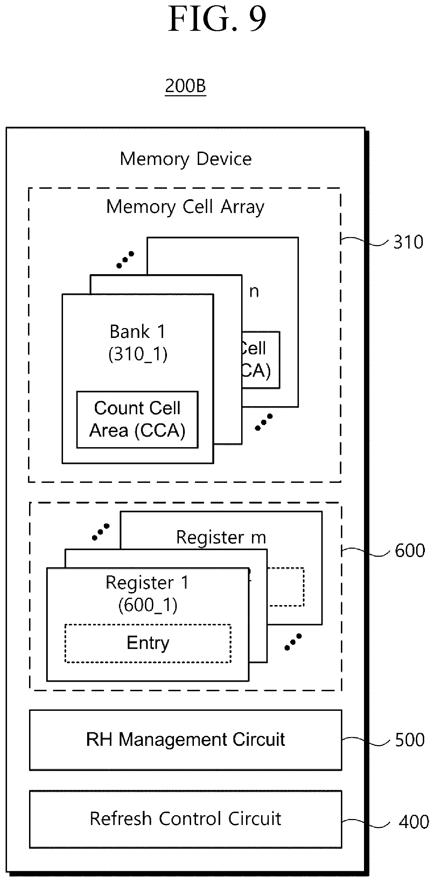

FIG. 9 is a block diagram of an example of a memory device according to some implementations. In FIG. 9, a memory device 200B may be an implementation of the memory devices 200 and 200A of FIGS. 1 and 4, but the present disclosure is not limited thereto. In FIG. 9, the description associated with components similar to the above components will be omitted or simplified.

In FIG. 9, the memory device 200B may include the memory cell array 310, the row hammer management circuit 500, the refresh control circuit 600, and a register group 600.

According to some implementations, count data stored in a plurality of count cells may be managed through a register. To this end, the memory device 200B may include the register group 600. The register group 600 may include a plurality of registers 600_1 to 600_m. In this case, one register may correspond to one bank. In some implementations, one register may correspond to a plurality of banks.

Each of the plurality of registers 600_1 to 600_m may store information about some of a plurality of rows included in the corresponding bank. For example, each of the plurality of registers 600_1 to 600_m may store an address and count data, which are associated with a row having relatively large count data from among the plurality of rows included in the corresponding bank. In this case, an address and count data associated with one row managed in the register may be referred to as an "entry". According to some implementations, the register may include a plurality of entries. In some implementations, the register may include one entry.

The row hammer management circuit 500 may update the register group 600 by using modified count data of a target row, which are generated through the RWM operation. For example, the row hammer management circuit 500 may select a register, which corresponds to a bank to which the target row belongs, from among registers of the register group 600. Afterwards, the row hammer management circuit 500 may compare addresses and count data of rows managed in the selected register with the address and the modified count data of the target row. Based on a comparison result, the row hammer management circuit 500 may manage an address and count data of a row having relatively large count data from among a plurality of rows of the bank in a register.

Meanwhile, when the above row hammer refresh opportunity is given, the memory device 200B may perform the row hammer refresh operation based on information of a row managed in a register of the register group 600. According to some implementations, the row hammer management circuit 500 may select a row having the largest count data from among rows managed in a register as a management aggressor row and may provide the row hammer address RH_ADDR corresponding to the selected management aggressor row to the refresh control circuit 400. The refresh control circuit 400 may generate the refresh row address REF_ADDR corresponding to a victim row(s) adjacent to the management aggressor row based on the received row hammer address RH_ADDR and may output the generated refresh row address REF_ADDR. Accordingly, as the victim row(s) is refreshed, the row hammer refresh operation may be performed.

Meanwhile, when the row hammer refresh operation on the victim row(s) is performed, the row hammer management circuit 500 may reset count data corresponding to the management aggressor row. In this case, the row hammer management circuit 500 may reset both count data of the count cell area and count data of the register, which correspond to the management aggressor row. Accordingly, both the count data stored in the count cell area corresponding to the management aggressor row and the count data stored in the register corresponding to the management aggressor row may be reset.

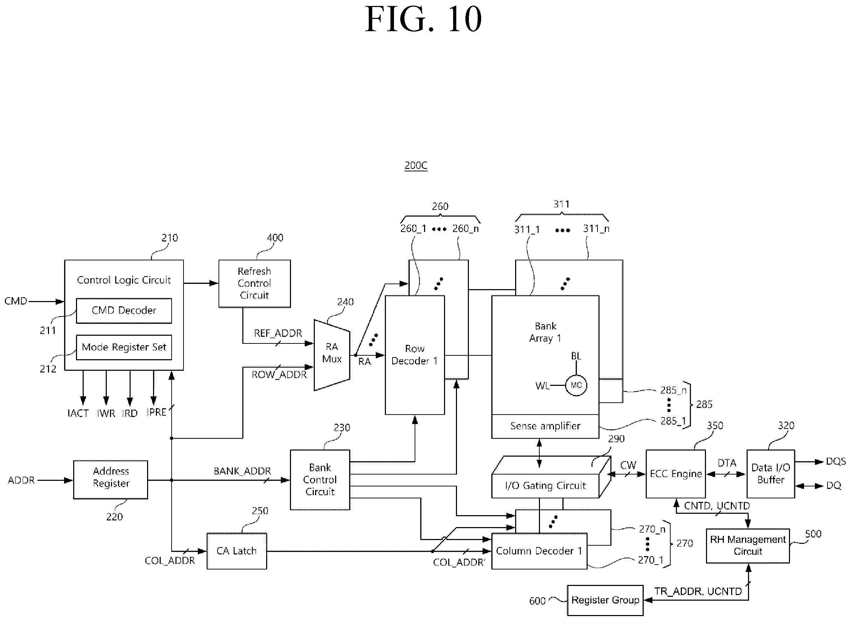

FIG. 10 is a block diagram illustrating an example of a memory device according to some implementations. In FIG. 10, a memory device 200C may be an implementation of one of the memory devices 200, 200A, and 200B of FIGS. 1, 4, and 9, but the present disclosure is not limited thereto. In FIG. 10, the description which is given above will be omitted or simplified.

In FIG. 10, the memory device 200C may include the control logic circuit 210, an address register 220, a bank control circuit 230, the refresh control circuit 400, a row address multiplexer 240, a column address latch 250, a row decoder 260, a column decoder 270, a bank array group 311, a sense amplifier unit 285, an input/output gating circuit 290, an ECC engine 350, a data input/output buffer 320, the row hammer management circuit 500, and the register group 600.

The bank array group 311 may include the plurality of bank arrays 311_1 to 311_n. Each of the plurality of bank arrays 311_1 to 311_n may include a plurality of memory cells. For example, each of the plurality of memory cells may be formed at an intersection of a corresponding word line and a corresponding bit line.

The row decoder 260 may include a plurality of sub-row decoders 260_1 to 260_n. Each of the plurality of sub-row decoders 260_1 to 260_n may be connected to the corresponding bank array among the plurality of bank arrays 311_1 to 311_n.

The sense amplifier unit 285 may include a plurality of sense amplifiers 285_1 to 285_n. Each of the plurality of sense amplifiers 285_1 to 285_n may be connected to the corresponding bank array among the plurality of bank arrays 311_1 to 311_n.

The column decoder 270 may include a plurality of sub-column decoders 270_1 to 270_n. Each of the plurality of sub-column decoders 270_1 to 270_n may be connected to the corresponding bank array among the plurality of bank arrays 311_1 to 311_n through the corresponding sense amplifier.

The plurality of bank arrays 311_1 to 311_n, the plurality of sense amplifiers 285_1 to 285_n, the plurality of sub-column decoders 270_1 to 270_n, and the plurality of sub-row decoders 260_1 to 260_n may constitute a plurality of banks. For example, the first bank array 311_1, the first sense amplifier 285_1, the first sub-column decoder 270_1, and the first sub-row decoder 260_1 may constitute the first bank.

The address register 220 may receive an address ADDR including a bank address BANK ADDR, a row address ROW ADDR, and a column address COL_ADDR from the memory controller 100. The address register 220 may provide the received bank address BANK_ADDR to the bank control circuit 230, may provide the received row address ROW_ADDR to the row address multiplexer 240, and may provide the received column address COL_ADDR to the column address latch 250. Also, the address register 220 may provide the bank address BANK_ADDR and the row address ROW_ADDR to the row hammer management circuit 500.

The bank control circuit 230 may generate bank control signals in response to the bank address BANK_ADDR. For example, a sub-row decoder corresponding to the bank address BANK_ADDR from among the plurality of sub-row decoders 260_1 to 260_n may be activated in response to the bank control signals. Also, a sub-column decoder corresponding to the bank address BANK_ADDR from among the plurality of sub-column decoders 270_1 to 270_n may be activated in response to the bank control signals.

The row address multiplexer 240 may receive the row address ROW_ADDR from the address register 220 and may receive the refresh row address REF_ADDR from the refresh control circuit 400. The row address multiplexer 240 may selectively output the row address ROW _ADDR or the refresh row address REF _ADDR as the row address RA. The row address RA output from the row address multiplexer 240 may be applied to each of the plurality of sub-row decoders 260_1 to 260_n.

The refresh control circuit 400 may perform the normal refresh operation or the row hammer refresh operation. In detail, the refresh control circuit 400 may perform the normal refresh operation or the row hammer refresh operation by outputting the refresh row address REF _ADDR under control of the control logic circuit 210.

According to some implementations, the refresh control circuit 400 may perform the normal refresh operation based on the refresh (REF) command. In this case, the refresh control circuit 400 may output the refresh row address REF_ADDR corresponding to a row where the normal refresh operation is to be performed, based on the refresh (REF) command. Meanwhile, the refresh control circuit 400 may sequentially perform the normal refresh operations on physically adjacent rows among rows of a bank.

According to some implementations, when the above row hammer refresh opportunity is given, the refresh control circuit 400 may perform the row hammer refresh operation. In this case, the refresh control circuit 400 may output the refresh row address REF_ADDR corresponding to a victim row(s) physically adjacent to a management aggressor row, based on the received row hammer address RH_ADDR.

A sub-row decoder selected by the bank control circuit 230 from among the plurality of sub-row decoders 260_1 to 260_n may activate a word line corresponding to the row address RA output from the row address multiplexer 240. For example, the selected sub-row decoder may apply a word line driving voltage to the word line corresponding to a row address.

The column address latch 250 may receive the column address COL_ADDR from the address register 220 and may temporarily store the received column address COL_ADDR. Also, for example, in a burst mode, the column address latch 250 may gradually increase the received column address COL_ADDR. The column address latch 250 may apply a temporarily stored or gradually increased column address COLADDR' to each of the plurality of sub-column decoders 270_1 to 270_n.

A sub-column decoder activated by the bank control circuit 230 from among the plurality of sub-column decoders 270_1 to 270_n may activate a sense amplifier corresponding to the bank address BANK_ADDR and the column address COL_ADDR through the input/output gating circuit 290.

The input/output gating circuit 290 may include circuits which gate input/output data. Also, the input/output gating circuit 290 may include data latches for storing codewords output from the plurality of bank arrays 311_1 to 311_n and write drivers for writing data in the plurality of bank arrays 311_1 to 311_n.

In the read operation, a codeword CW read from a bank array selected from the plurality of bank arrays 311_1 to 311_n may be sensed by a sense amplifier corresponding to the selected bank array and may be stored in the data latches of the input/output gating circuit 290. Also, the codeword CW stored in the data latches may be ECC-decoded by the ECC engine 350 so as to be provided to the data input/output buffer 320 as data DTA. The data input/output buffer 320 may generate a data signal DQ based on the data DTA and may provide the data signal DQ to the memory controller 100 together with a strobe signal DQS.

In the write operation, the data DTA to be written in a bank array selected from the plurality of bank arrays 311_1 to 311_n may be received by the data input/output buffer 320 as the data signal DQ. The data input/output buffer 320 may convert the data signal DQ into the data DTA so as to be provided to the ECC engine 350. The ECC engine 350 may generate parity bits (or parity data) based on the data DTA and may provide the input/output gating circuit 290 with the codeword CW including the data DTA and the parity bits. The input/output gating circuit 290 may write the codeword CW to the selected bank array.

In the write operation, the data input/output buffer 320 may convert the data signal DQ into the data DTA so as to be provided to the ECC engine 350. In the read operation, the data input/output buffer 320 may convert the data DTA provided from the ECC engine 350 into the data signal DQ.

In the write operation, the ECC engine 350 may perform ECC encoding for the data DTA. In the read operation, the ECC engine 350 may perform ECC decoding for the codeword CW. Also, the ECC engine 350 may perform ECC encoding and ECC decoding for the count data CNTD provided from the row hammer management circuit 500.

The control logic circuit 210 may control an operation of the memory device 200C. For example, the control logic circuit 210 may generate control signals such that the memory device 200C performs the write operation, the read operation, the normal refresh operation, and the row hammer refresh operation. The control logic circuit 210 may include a command decoder 211 which decodes the command CMD received from the memory controller 100 and a mode register (MRS) 212 for setting an operation mode of the memory device 200C.

The command decoder 211 may decode the command CMD to generate internal command signals such as an internal active signal IACT, an internal precharge signal IPRE, an internal read signal IRD, and an internal write signal IWR. Also, the command decoder 211 may generate control signals corresponding to the command CMD by decoding a chip select signal, a command/address signal, etc.

The row hammer management circuit 500 may perform various kinds of operations for managing a row hammer phenomenon which occurs in the memory device 200C. For example, the row hammer management circuit 500 may select a management aggressor row among a plurality of rows based on count data stored in a plurality of count cells. In this case, the row hammer management circuit 500 may provide the row hammer address RH_ADDR corresponding to the selected management aggressor row to the refresh control circuit 400. Also, the row hammer management circuit 500 may manage the count data for each of the plurality of rows.

According to some implementations, the row hammer management circuit 500 may receive the count data CNTD from the ECC engine 350. The row hammer management circuit 500 may modify the count data CNTD and may again provide modified count data UCNTD to the ECC engine 350.

In some implementations, when an ACT command for a target row is applied, the count data CNTD stored in a count cell of the target row and parity data stored in a parity cell of the target row may be provided to the ECC engine 350. The ECC engine 350 may perform the ECC decoding operation on the count data CNTD by using the parity data and may transfer the count data CNTD to the row hammer management circuit 500. The row hammer management circuit 500 may generate the modified count data UCNTD by increasing the count data CNTD as much as "1" or increasing the count data CNTD as much as "k" (k being a natural number of 2 or more) in consideration of the activation time of the target row. The row hammer management circuit 500 may provide the modified count data UCNTD to the ECC engine 350, and the ECC engine 350 may generate the parity data through the ECC encoding operation on the modified count data UCNTD. The modified count data UCNTD and the parity data associated with the modified count data UCNTD may be stored in the count cell and the parity cell of the target row.

According to some implementations, the row hammer management circuit 500 may transmit an address TR_ADDR and the modified count data UCNTD of the target row to the register group 600. The row hammer management circuit 500 may selectively update the register group 600 by using the address TR_ADDR and the modified count data UCNTD of the target row.

In some implementations, the row hammer management circuit 500 may select a register, which corresponds to a bank to which the target row belongs, from among registers of the register group 600. The row hammer management circuit 500 may compare an address and/or count data managed in the selected register with the address TR_ADDR and/or the modified count data UCNTD of the target row and may update the register based on a comparison result. For example, when at least one of pieces of count data of entries of the register is smaller than the modified count data UCNTD of the target row, the row hammer management circuit 500 may replace the entry of the register corresponding to the smallest count data with the address TR_ADDR and the modified count data UCNTD of the target row. As the memory device 200C manages an address and count data associated with a row having relatively large count data from among a plurality of rows through the register group 600, the memory device 200C may manage the risk of occurrence of the row hammer phenomenon for each row to be an appropriate level or lower and may effectively prevent the row hammer phenomenon.

According to some implementations, the row hammer management circuit 500 may reset count data. For example, the row hammer management circuit 500 may reset count data corresponding to a row, at which the normal refresh operation is performed, from among a plurality of rows. In some implementations, the row hammer management circuit 500 may reset count data corresponding to a row where the normal refresh operation is performed, based on the refresh row address REF _ADDR which the refresh control circuit 400 outputs. Meanwhile, when the row hammer refresh operation is performed, the row hammer management circuit 500 may reset count data corresponding to a management aggressor row.

In FIG. 10, the memory device 200C includes the ECC engine 350. However, this is provided as an example. According to some implementations, the memory device 200 may not include an ECC engine. In this case, the row hammer management circuit 500 may read count data of a count cell of a target row through the input/output gating circuit 290, may increase the read count data to generate modified count data, and may again write the modified count data to the count cell of the target row through the input/output gating circuit 290.

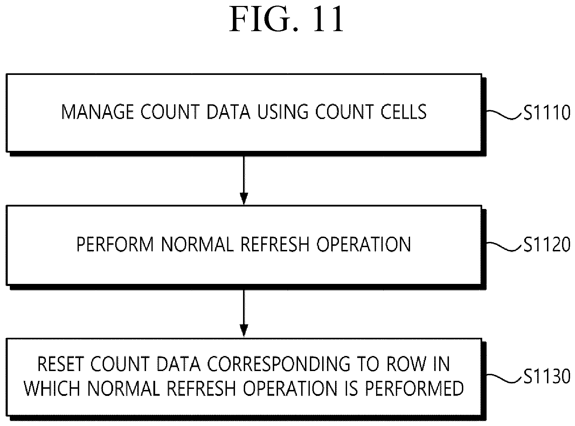

FIG. 11 is a flowchart illustrating an example of an operating method of a memory device according to some implementations. In FIG. 11, in operation S1110, the memory device 200 may manage count data by using count cells. In detail, the memory device 200 may manage count data being the number of times of access of each of a plurality of rows, by using the count cells of the count cell area CCA of a bank. According to some implementations, the memory device 200 may perform the RMW operation to manage the count data of each of the plurality of rows.

In operation S1120, the memory device 200 may perform the normal refresh operation. For example, the memory device 200 may perform the normal refresh operation through an operation of outputting the refresh row address REF_ADDR corresponding to a row, at which the normal refresh operation is to be performed, to the memory cell array 310, based on the refresh (REF) command received from the memory controller 100.

In operation S1130, the memory device 200 may reset count data corresponding to the row where the normal refresh operation is performed, from among the plurality of rows. For example, the memory device 200 may reset the count data corresponding to the row which is normal-refreshed, based on the refresh row address REF_ADDR.

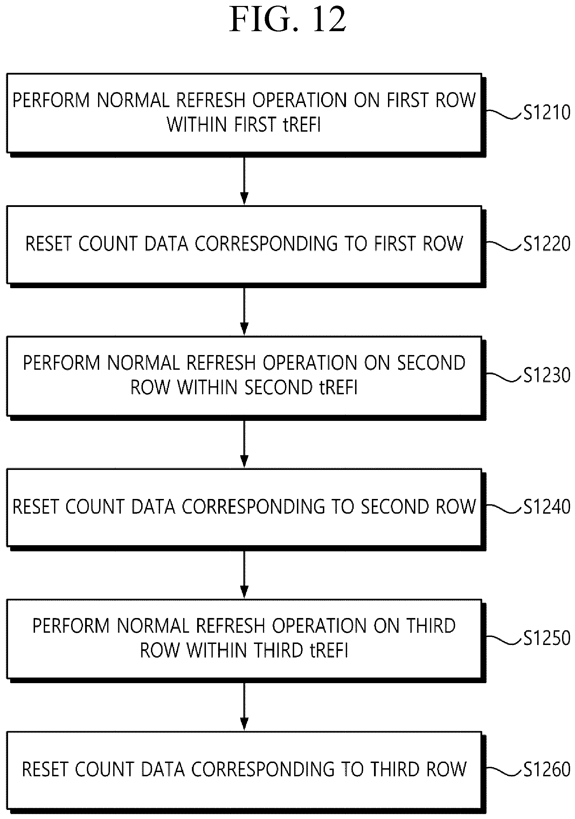

FIG. 12 is a flowchart illustrating an example of an operating method of a memory device according to some implementations. In FIG. 12, operation S1210, operation S1230, and operation S1250 may correspond to operation S1120 of FIG. 11, and operation S1220, operation S1240, and operation S1260 may correspond to operation S1130 of FIG. 11. However, the present disclosure is not limited thereto.

According to some implementations, the memory device 200 may sequentially perform the normal refresh operations on rows physically adjacent from among rows of a bank. In this case, the memory device 200 may perform the normal refresh operations on the physically adjacent rows respectively within the tREFIs close to each other on time. Accordingly, count data corresponding to the physically adjacent rows may be sequentially reset depending on the order of the normal refresh operations.

In FIG. 12, in operation S1210, the memory device 200 may perform the normal refresh operation on the first row within a first tREFI. In this case, in operation S1220, the memory device 200 may reset count data corresponding to the first row.

Afterwards, in operation S1230, the memory device 200 may perform the normal refresh operation on the second row adjacent to the first row within a second tREFI following the first tREFI. In this case, in operation S1240, the memory device 200 may reset count data corresponding to the second row.

Afterwards, in operation S1250, the memory device 200 may perform the normal refresh operation corresponding to the third row adjacent to the second row within a third tREFI following the second tREFI. In this case, in operation S1260, the memory device 200 may reset count data corresponding to the third row.

Additionally, according to some implementations, unlike FIG. 12, the memory device 200 may perform the normal refresh operation such that a plurality of rows physically adjacent to each other are refreshed within one tREFI. In this case, for example, the memory device 200 may sequentially perform the normal refresh operation on the first row and the normal refresh operation on the second row adjacent to the first row within the first tREFI. Accordingly, the count data corresponding to the first row and the second row may be sequentially reset. Afterwards, the memory device 200 may sequentially perform the normal refresh operation on the third row adjacent to the second row and the normal refresh operation on the fourth row adjacent to the third row within the second tREFI following the first tREFI. Accordingly, the count data corresponding to the third row and the fourth row may be sequentially reset.

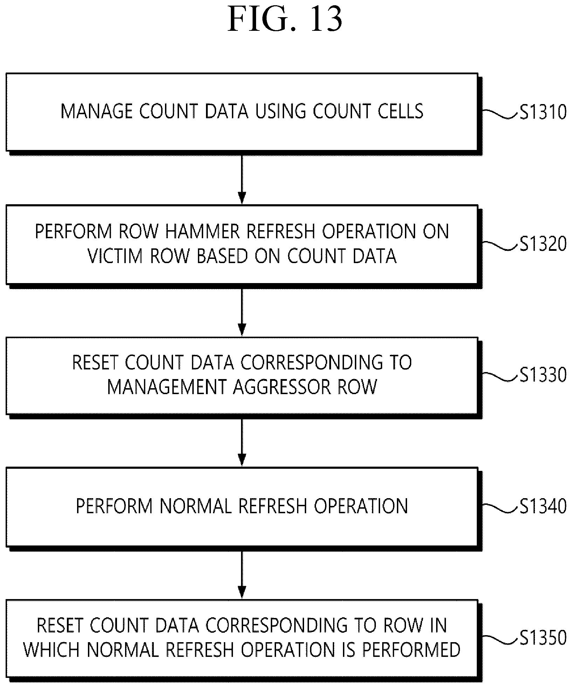

FIG. 13 is a flowchart illustrating an example of an operating method of a memory device according to some implementations. In FIG. 13, operation S1310 may correspond to operation S1110 of FIG. 11, and operation S1340 may correspond to operation S1120 of FIG. 11. Additionally, operation S1350 of FIG. 13 may correspond to operation S1130 of FIG. 11. However, the present disclosure is not limited thereto.

In FIG. 13, in operation S13 10, the memory device 200 may manage count data being the number of times of access of each of a plurality of rows by using count cells of a count cell area.

In operation S1320, the memory device 200 may perform the row hammer refresh operations on victim rows based on count data. For example, the memory device 200 may select a management aggressor row among the plurality of rows based on the count data stored in the plurality of count cells. Accordingly, the memory device 200 may perform the row hammer refresh operation on a victim row(s) adjacent to the selected management aggressor row.

After the row hammer refresh operation is performed, the risk of occurrence of the row hammer of the victim row(s) due to the management aggressor row may be removed. Accordingly, in operation S1330, the memory device 200 may reset count data corresponding to the management aggressor row.

Meanwhile, in operation S1340, the memory device 200 may perform the normal refresh operation. Also, in operation S1350, the memory device 200 may reset count data corresponding to a row where the normal refresh operation is performed, from among the plurality of rows.

Meanwhile, the normal refresh operation refers to an operation of refreshing all the rows during the tREFW through the iterative execution, and the row hammer refresh operation refers to an operation of refreshing a specific row(s) with a high row hammer risk when the row hammer refresh opportunity is given. Accordingly, the order of operations S1320 and S1330 associated with the row hammer refresh operation and operations S1340 and S1350 associated with the normal refresh operation is not limited to the implementation in FIG. 13. That is, in some cases, of course, operations S1340 and S1350 associated with the normal refresh operation may be performed prior to operations S1320 and S1330 associated with the row hammer refresh operation.

According to some implementations, a memory device capable of effectively managing a row hammer issue and an operating method of the memory device may be provided. Accordingly, the performance and reliability of the memory device may be improved.

While this disclosure contains many specific implementation details, these should not be construed as limitations on the scope of what may be claimed. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

## Claims

1. A memory device comprising:
a bank (310_1) including a plurality of rows, each row including memory cells and a set of count cells (CC1 to CCj) configured to store count data associated with a number of times that each of the plurality of rows is accessed; and
a row hammer management circuit (500) configured to:
manage the count data of each row of the plurality of rows of the bank (310_1), and
reset the count data corresponding to each row of the plurality of rows in response to a normal refresh operation being performed.

2. The memory device of claim 1, wherein, in response to the normal refresh operation on a target row of the plurality of rows, the row hammer management circuit (500) is configured to reset the count data corresponding to the target row.

3. The memory device of claim 1 or 2, further comprising a refresh control circuit (400) configured to perform the normal refresh operation based on a refresh command.

4. The memory device of claim 3,
wherein the refresh control circuit (400) is configured to output a refresh row address (REF_ADDR) corresponding to the row where the normal refresh operation is performed based on the refresh command, and
wherein the row hammer management circuit (500) is configured to reset count data corresponding to the row where the normal refresh operation is performed based on the refresh row address (REF ADDR).

5. The memory device of claim 3 or 4, wherein the refresh control circuit (400) is configured to perform the normal refresh operation on physically adjacent rows sequentially.

6. The memory device of claim 5,
wherein the physically adjacent rows include a first row, a second row adjacent to the first row, and a third row adjacent to the second row, and
wherein the refresh control circuit (400) is configured to:
perform the normal refresh operation on the first row within a first reference interval time;
perform the normal refresh operation on the second row within a second reference interval time following the first reference interval time; and
perform the normal refresh operation on the third row within a third reference interval time following the second reference interval time.

7. The memory device of claim 5,
wherein the physically adjacent rows include a first row, a second row adjacent to the first row, a third row adjacent to the second row, and a fourth row adjacent to the third row, and
wherein the refresh control circuit (400) is configured to:
perform the normal refresh operation on the first row and the second row sequentially within a first reference interval time; and
perform the normal refresh operation on the third row and the fourth row sequentially within a second reference interval time following the first reference interval time.

8. The memory device of any one of claims 5 to 7, wherein the row hammer management circuit (500) is configured to sequentially reset count data corresponding to the physically adjacent rows.

9. The memory device of any one of claims 1 to 8, wherein the plurality of rows of the bank (310_1) are refreshed one or more times by the normal refresh operation during one refresh window time.

10. The memory device of any one of claims 3 to 9,
wherein the refresh control circuit (400) is configured to perform a row hammer refresh operation on at least one victim row physically adjacent to a management aggressor row, and
wherein the management aggressor row is selected from the plurality of rows based on the count data stored in a plurality of count cells.

11. The memory device of claim 10, wherein, in response to the row hammer refresh operation on the at least one victim row being performed, the row hammer management circuit (500) is configured to reset count data corresponding to the management aggressor row.

12. An operation method of a memory device comprising a bank including a plurality of rows including memory cells and a count cell area including count cells, the method comprising:
managing (S1110) count data using count cells, the count data indicating a number of times that each row of a plurality of rows is accessed;
performing (S1120; S1210, S1230, S1240; S1340) a normal refresh operation; and
resetting (S1130; S1220, S1240, S1260; S1350) the count data corresponding to each row of the plurality of rows in response to the normal refresh operation being performed.

13. The method of claim 12,
wherein performing (S1120; S1210, S1230, S1240; S1340) of the normal refresh operation includes:
outputting, to the bank, a refresh row address corresponding to a target row where the normal refresh operation is performed based on a refresh command, and
wherein resetting (S1130; S1220, S1240, S1260; S1350) of the count data includes resetting count data corresponding to the target row where the normal refresh operation is performed based on the refresh row address.

14. The method of claim 12 or 13, wherein performing (S1120; S1210, S1230, S1240; S1340) of the normal refresh operation includes performing the normal refresh operation on physically adjacent rows sequentially.

15. The method of claim 14,
wherein the physically adjacent rows include a first row, a second row adjacent to the first row, and a third row adjacent to the second row, and
wherein performing (S1210, S1230, S1240) of the normal refresh operation includes:
performing (S1210) the normal refresh operation on the first row within a first reference interval time;
performing (S1230) the normal refresh operation on the second row within a second reference interval time following the first reference interval time; and
performing (S1240) the normal refresh operation on the third row within a third reference interval time following the second reference interval time.
